# EUROPÄISCHE PATENTANMELDUNG

(11) **EP 3 382 753 A1**
(43) Veröffentlichungstag der Anmeldung: **03.10.2018**
(21) Anmeldenummer: 17163861.2
(22) Anmeldetag: 30.03.2017
(51) Int. Cl.: H01L 23/24, H01L 23/051, H01L 23/00

(54) **ISOLATION FÜR EINE MEHRLAGIGE ELEKTRISCHE SCHALTUNG UND VERFAHREN ZUR HERSTELLUNG EINER ISOLATION**

(71) Anmelder: Siemens Aktiengesellschaft, 80333 München (DE)
(72) Erfinder: Bigl, Thomas, 91074 Herzogenaurach (DE); Hensler, Alexander, 90766 Fürth (DE); Ochs, Ewgenij, 90765 Fürth (DE); Pfefferlein, Stefan, 90562 Heroldsberg (DE)

(57) **Zusammenfassung**

Die Erfindung betrifft ein Herstellverfahren und eine Isolation für eine mehrlagige elektrische Schaltung, wobei auf der ersten Lage (L1) eine zweite Lage (L2) angeordnet ist, insbesondere eine Oberfläche eines auf dem ersten Schaltungsträger montierten Leistungshalbleiters oder eine andere potentialbehaftete Fläche, wobei die erste Lage (L1) die zweite Lage (L2) allseitig überragt, wobei eine dritte Lage (L3), insbesondere ein zweiter Schaltungsträger, auf der zweiten Lage (L2) angeordnet ist, und wobei auch die dritte Lage (L3) die zweite Lage (L2) allseits überragt. Dabei ist zwischen der ersten (L1) und der dritten (L3) Lage vollumfänglich um die zweite Lage (L2) herum und von dieser zweiten Lage (L2) jeweils beabstandet eine Barriere (B) angeordnet, wobei die Barriere (B) an der ersten Lage (L1) und der dritten Lage (L3) jeweils anliegt oder mit dieser jeweils stoffschlüssig verbunden ist, wobei zwischen der ersten (L1) und der dritten Lage (L3) und zwischen den Seiten der zweiten Lage (L2) und der Barriere (B) ein Füllraum (K) gebildet ist, und wobei der Füllraum (K) mit einem Isoliermaterial verfüllt ist. Durch diese Isolation ist eine platzsparende und sehr betriebssichere Ausführung der elektrischen Schaltung möglich, wobei das Herstellen der Isolation im laufenden Fertigungsbetrieb der elektrischen Schaltung leicht umsetzbar ist.

## Beschreibung

Die Erfindung betrifft eine Isolation für eine mehrlagige elektrische Schaltung gemäß dem Oberbegriff des Patentanspruchs 1, und ein Verfahren zur Herstellung einer Isolation für eine mehrlagige elektrische Schaltung gemäß dem Oberbegriff des Patentanspruchs 10.

Bei leistungselektronischen Schaltungen müssen potentialbehaftete Teile gegenüber anderen Potentialen, insbesondere gegenüber dem Erdpotential, ausreichend isoliert sein. In den Normen sind dafür einzuhaltende Abstände in Form von Luft- und Kriechstrecken vorgegeben. Eine kritische Stelle ist dabei stets das Einhalten der Isolierabstände bei der thermischen Anbindung von Leistungsbauelementen an einen Kühlkörper, der zumeist auf Erdpotential liegt. Zwischen der in der Regel potentialbehafteten Oberfläche des Leistungshalbleiters und dem auf Erdpotential liegenden Kühlkörper ist regelmäßig eine isolierende Schicht, beispielsweise eine Isolationsfolie oder Isolationsschicht (z.B. Glimmerplättchen) oder ein anderes elektrisch isolierendes Material angeordnet, wobei diese Isolierschicht beziehungsweise das Isoliermaterial zur Einhaltung der erforderlichen Isolierabstände die potentialbehaftete Oberfläche des Leistungshalbleiters allseitig überragen muss, was zum einen den Platzbedarf erhöht, und wobei zum anderen sichergestellt sein muss, dass in den entstehenden Spalt zwischen einem Schaltungsträger, dem Isoliermaterial und (seitlich) neben dem Leistungshalbleiter keine Fremdkörper eindringen können, insbesondere Staub oder gar Metallpartikel.

Um diese Probleme zu lösen oder zumindest zu verringern, ist es üblich, dass bei Elektronikmodulen beispielsweise bestehend aus Leistungshalbleitern und darauf befindlichen Kühlkörpern oder weiteren Schaltungsträgern (z. B. in "SandwichBauweise") die kompletten Elektronikmodule durch das Vergießen mit einer elektrisch isolierenden Vergussmasse isoliert werden; man spricht dabei auch von einem "Vollverguss". Damit werden die erforderlichen Isolationsstrecken verkürzt, weil die isolierenden Eigenschaften der gebräuchlichen Vergussmassen wesentlich besser sind, als die von Luft. Auch das spätere Eindringen von Staub, Feuchtigkeit und Fremdkörpern bzw. Partikeln wird dabei verhindert. Oft wird zum Vergießen ein Gehäuse der elektrischen Schaltung, beispielsweise ein Modulgehäuse, gleichzeitig als Gussform verwendet. Durch diese Maßnahmen kann der Isolationsabstand auf einen Bruchteil der sonst dafür benötigten Luft- und Kriechstrecke reduziert werden.

Während das geschilderte Verfahren mit Vollverguss für kleine Module mit wenigen Bauteilen und einfachen, nicht verwinkelten Geometrien und bei geringen Anforderungen an die Wärmeabfuhr gut geeignet ist, stößt das geschilderte Herstellungsverfahren bei höheren Integrationsstufen der Leistungselektronik und abseits der herkömmlichen Modulaufbauweise an Grenzen. Beispielsweise wird oft ein Leistungshalbleiter in ein Sandwich aus zwei Schaltungsträgern eingebettet, wobei mindestens einer der beiden Schaltungsträger eine thermische Anbindung an den Kühlkörper gewährleisten muss. Im Stand der Technik wird dabei die wirksame Luft- und Kriechstrecke zum Kühlkörper in Form eines umlaufenden Überhangs, d. h. einer Vergrößerung der Isolationslage (z. B. als Al₂O₃ bei herkömmlichen DCB-Substraten) verlängert. Dies ist allerdings mit den bereits geschilderten Nachteilen eines erhöhten Platzbedarfs sowie einer vergrößerten Bruchempfindlichkeit beim Handling und bei der Montage der spröden Isolationsmaterialien verbunden. Zusätzlich können, wie bereits geschildert, in einen Spalt zwischen dem Schaltungsträger und dem umlaufenden Überhang der Isolationslage leitfähige Partikel eindringen und die wirksame Isolationsstrecke verkürzen.

Auch bei solchen und ähnlichen mehrlagigen Anordnungen, beispielsweise mit zwischen zwei Schaltungsträgern eingebetteten Leistungshalbleitern, könnte durch ein Einfüllen von elektrisch isolierendem Vergussmaterial in den Spalt zwischen dem zugrundeliegenden Schaltungsträger und dem umlaufenden Isolationsüberhang des zweiten Schaltungsträgers die Isolationsstrecke verkürzt werden. Dies ist allerdings in der Praxis schwer umsetzbar, weil eine Verkippung der relativ großflächigen Schaltungsträger zueinander oder eine Verwölbung zu undefinierten Spaltmaßen und damit zu einem wechselnden Volumen der Vergussmasse führt. Prozessbedingte Verunreinigungen, die sich zwischen den Schaltungsträgern im Isolierspalt befinden, würden ohne eine Vorreinigung durch die Vergussmasse eingeschlossen, so dass eine vorherige Reinigung des relativ großflächigen, aber dünnen Isolierspaltes notwendig ist, jedoch schwer durchzuführen ist. Auch eine spätere Prüfung der Isolationseigenschaften ist schwer möglich. Insgesamt ist damit das vollständige Verfüllen zur Einhaltung der Luft- und Kriechstrecke bei solchen Modulen kaum möglich.

Es ist also eine Aufgabe der Erfindung, eine verbesserte Isolation zur Verkürzung der Luft- und Kriechstrecken bei mehrlagigen elektrischen Schaltungen anzugeben.

Es ist ein Kernelement der erfindungsgemäßen Lösung dieser Aufgabe, dass bei einer mehrlagigen elektrischen Schaltung zwischen der oberen und unteren Lage, zwischen der ein potentialbehaftetes Bauteil, insbesondere ein Leistungshalbleiter, angeordnet ist, umlaufend um die potentialbehaftete Zwischenlage bzw. der Oberfläche des eingebetteten Leistungshalbleiters und beabstandet von diesem Leistungshalbleiter bzw. der potentialbehafteten Zwischenlage eine dichte Barriere in Form eines potentialfreien Rings oder dergleichen auszubilden, wobei diese Barriere somit Teil einer Gussform einer Isolationsmasse oder Vergussmasse bildet. Über einen strukturierten Graben oder eine ähnliche Füllöffnung kann dann ein Fließkanal, ähnlich einem Speiser in der Gießereitechnik, zur Verfüllung des sich bildenden Hohlraumes ("Kavität") erstellt werden, der mit der Vergussmasse auch bei geringer Spaltgängigkeit sicher gefüllt werden kann.

Die Erfindung wird insbesondere durch eine Isolation gemäß dem Patentanspruch 1 und durch ein Verfahren gemäß dem Patentanspruch 10 gelöst.

Dabei wird eine Isolation für eine mehrlagige elektrische Schaltung vorgeschlagen, wobei auf der ersten Lage eine zweite Lage angeordnet ist, insbesondere eine Oberfläche eines auf dem ersten oder zweiten Schaltungsträger montierten Leistungshalbleiters oder eine andere potentialbehaftete Fläche, wobei die erste Lage die zweite Lage allseitig überragt, wobei eine dritte Lage, insbesondere ein zweiter Schaltungsträger, auf der zweiten Lage angeordnet ist, und wobei auch die dritte Lage die zweite Lage allseits überragt. Dabei ist zwischen der ersten und der dritten Lage vollumfänglich um die zweite Lage herum und von dieser zweiten Lage jeweils beabstandet eine Barriere angeordnet, wobei die Barriere an der ersten Lage und der dritten Lage jeweils anliegt oder mit dieser jeweils stoffschlüssig verbunden ist, wobei zwischen der ersten und der dritten Lage und zwischen den Seiten der zweiten Lage und der Barriere ein Füllraum gebildet ist, und wobei der Füllraum mit einem Isoliermaterial verfüllt ist. Durch diese Isolation ist eine platzsparende und sehr betriebssichere Ausführung der elektrischen Schaltung möglich, wobei das Herstellen der Isolation im laufenden Fertigungsbetrieb der elektrischen Schaltung leicht umsetzbar ist.

Die Aufgabe wird ebenfalls durch ein Verfahren zur Herstellung einer Isolation einer mehrlagigen elektrischen Schaltung gelöst, wobei eine erste Lage der Schaltung durch einen ersten Schaltungsträger gebildet ist, wobei auf der ersten Lage eine zweite Lage angeordnet ist, insbesondere eine Oberfläche eines auf dem ersten Schaltungsträger montierten Leistungshalbleiters oder eine andere potentialbehaftete Fläche, wobei die erste Lage die zweite Lage allseitig überragt, wobei eine dritte Lage, insbesondere ein zweiter Schaltungsträger, auf der zweiten Lage angeordnet ist, und wobei auch die dritte Lage die zweite Lage allseits überragt. Dabei wird zwischen der ersten und der dritten Lage vollumfänglich um die zweite Lage herum und von dieser beabstandet eine Barriere angeordnet, wobei die Barriere an der ersten Lage und der dritten Lage jeweils angelegt oder mit dieser jeweils stoffschlüssig verbunden wird, wobei zwischen der ersten und der dritten Lage und zwischen den Seiten der zweiten Lage und der Barriere ein Füllraum gebildet wird, und wobei der Füllraum mit einem Isoliermaterial verfüllt wird. Durch dieses Verfahren kann eine elektrische Schaltung mit einer Isolation hergestellt werden, die die bereits anhand des Verfahrens erläuterten Vorteile aufweist.

Vorteilhafte Ausgestaltungen der erfindungsgemäßen Isolation sind in den abhängigen Patentansprüchen angegeben. Die dabei beschriebenen Merkmale und deren Vorteile gelten sinngemäß auch für das erfindungsgemäße Verfahren. Die geschilderten Merkmale können sowohl einzeln, als auch in sinnvoller Kombination miteinander angewendet werden.

In einer vorteilhaften Ausgestaltung sind die erste und die dritte Lage im Bereich des Füllraums, also auf der jeweils dem Füllraum zugewandten Seite des jeweiligen Schaltungsträgers, elektrisch isolierend ausgebildet oder elektrisch isolierend beschichtet. Damit ist gewährleistet, dass die Grundfläche des Füllraums mit dem Vergussmaterial bzw. Isoliermaterial möglichst kleinflächig gehalten werden kann. Vorteilhaft ist der Füllraum im Wesentlichen umlaufend um die zweite Lage herum ausgebildet, so dass an allen Seiten der eingebetteten Lage die durch das Isoliermaterial ermöglichte Verkürzung der Isolationsstrecke realisiert werden kann.

Vorteilhaft weist die erste und/oder die dritte Lage im Bereich des Füllraums zumindest eine Öffnung zur Befüllung des Füllraums mit dem Isoliermaterial, insbesondere einem isolierenden Vergussmaterial, auf. Dadurch ist es möglich, das Isoliermaterial erst dann einzubringen, wenn die verschiedenen Lagen der elektrischen Schaltung bereits gefügt sind. In einer vorteilhaften Ausgestaltung sind dabei zumindest zwei Öffnungen oder eine großflächige Öffnung vorhanden, so dass zum einen das Befüllen erleichtert wird, insbesondere bei zähfließenden Verfüllmaterialien, und zum anderen es möglich ist, vor dem Füllvorgang bzw. dem Vergießen des Füllraums den Füllraum zu reinigen, insbesondere durch das Durchblasen von gereinigter Druckluft oder dem Spülen mit einem Reinigungsmittel.

Vorteilhaft ist die Barriere mit der ersten und/oder der dritten Lage stoffschlüssig verbunden. Zum einen führt dies vorteilhafterweise dazu, dass die Barriere dicht an dem jeweiligen Schaltungsträger angebunden ist, so dass ein Entweichen des Füllmaterials insbesondere während des Vergießens verhindert wird. Zum anderen führt das zu einer erhöhten Stabilität der mehrlagigen Anordnung sowohl während der Fertigung als auch im gebrauchsfertigen Zustand. Ebenso ist es von Vorteil, dass ein Eindringen von Medien aus der Umgebung unterdrückt wird.

Insbesondere zum Aufbau der bereits beschriebenen stoffschlüssigen Barriere kann vorteilhaft die erste und/oder die dritte Lage im Bereich ihres Anschlusses an die Barriere eine Metallisierung aufweisen, insbesondere nach Art einer Leiterbahn, wobei die Barriere mit dieser Metallisierung jeweils verlötet, verschweißt, verklebt oder versintert werden kann. Dazu ist es vorteilhaft, wenn die Barriere aus Metall, insbesondere aus Lötmaterial ("Lötzinn") gebildet wird. Prinzipiell ist es damit möglich, in einem gemeinsamen Arbeitsgang mit dem Verlöten der elektrischen Bauelemente im Lötprozess auch die Barriere auszubilden bzw. mit zumindest einer Lage der mehrlagigen Schaltung zu verbinden.

In einer vorteilhaften Ausgestaltung ist die Barriere gegenüber anderen potentialführenden Teilen, insbesondere gegenüber der zweiten Lage und anderen spannungsführenden Teilen der ersten und zweiten Lage, auf einem anderen elektrischen Potential.

Alternativ zu der geschilderten Ausführung der Barriere aus elektrisch leitfähigem Material, insbesondere Lötmaterial, kann die Barriere auch aus nichtleitendem Material, insbesondere aus einem elastischen Material, beispielsweise Silikon ausgeführt sein. Dadurch können beispielsweise mechanische Spannungen in Folge von thermischen Ausdehnungen verringert werden.

Ein Ausführungsbeispiel der erfindungsgemäßen Isolation wird nachfolgend anhand der Zeichnungen erläutert; das Ausführungsbeispiel dient gleichzeitig der Erläuterung des erfindungsgemäßen Verfahrens.

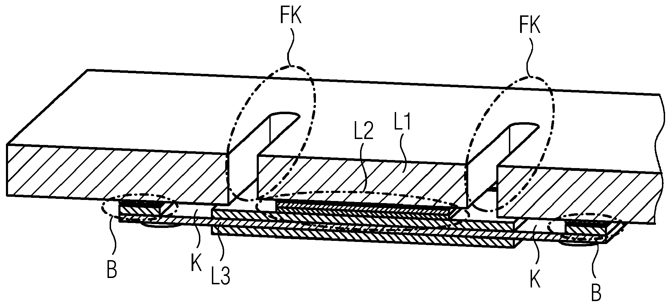

Dabei zeigt die einzige Figur in einer Schnittdarstellung eine mehrlagige elektrische Schaltung mit der erfindungsgemäßen Ausgestaltung zur Herstellung der Isolation.

In der Figur ist im oberen Bereich ein erster Schaltungsträger L1 als erste Lage einer mehrlagigen elektrischen Schaltung dargestellt. Auf bzw. - bezogen auf die Darstellung in der Figur - unter dem Schaltungsträger L1 ist als eine zweite Lage L2 ein potentialbehaftetes elektrisches Bauteil angeordnet, beispielsweise ein Leistungshalbleiter. Der Leistungshalbleiter ist in diesem Beispiel mit dem Schaltungsträger L1 verlötet. Auf der bzw. - bezogen auf die Darstellung in der Figur - unter der Lage L2 ist eine dritte Lage angeordnet, hier ein zweiter Schaltungsträger L3. Der zweite Schaltungsträger L3 kann dabei sowohl auf seiner Oberseite als auch auf seiner Unterseite potentialbehaftete Flächen, insbesondere Leiterbahnen bzw. metallisierte Bereiche aufweisen. Im Beispiel der Figur weist der zweite Schaltungsträger L3 sowohl auf seiner der Lage L2, also dem Leistungshalbleiter zugewandten Seite, als auch auf der gegenüberliegenden Seite jeweils eine metallisierte Fläche auf, was in diesem Ausführungsbeispiel dem besseren Wärmetransport dient und auch der Kontaktierung der Oberfläche des Leistungshalbleiters. An der dritten Lage, also dem zweiten Schaltungsträger L3, kann in diesem Bereich auch ein Kühlkörper angebunden sein, der jedoch in der Figur aus Gründen der Übersichtlichkeit nicht dargestellt ist. Es sei angenommen, dass alle drei gezeigten Lagen L1, L2, L3 direkt aufeinander aufliegen bzw. miteinander verbunden sind.

Zwischen den Schaltungsträgern L1 und L3 ist zunächst ein Luftspalt gegeben, der dadurch gegeben ist, dass die beiden Schaltungsträger L1 und L3 die mittlere Lage L2, also den Leistungshalbleiter, allseitig überragen. Sofern angenommen wird, dass der zweite Schaltungsträger L3 auf seiner (bezogen auf die Figur) Unterseite gegenüber der Lage L2 potentialbehaftete Strukturen aufweist oder mit einem metallischen Kühlkörper versehen ist (dies ist in der Figur durch eine schraffierte Auflage auf der Lage L3 angedeutet), bildet zunächst der Abstand zwischen den Seitenkanten der Lage L2 und dem Rand des Schaltungsträgers L3 eine Isolationsstrecke (Luft- oder Kriechstrecke), die im Stand der Technik aufgrund der physikalischen Eigenschaften des Isoliermediums "Luft" relativ groß bemessen sein muss.

In der Figur ist dargestellt, dass zwischen dem ersten Schaltungsträger L1 und dem zweiten Schaltungsträger L3 umlaufend um die Lage L2 und von dieser seitlich beabstandet eine Barriere B angeordnet ist, die aus dem zuvor offenen Luftspalt einen im Wesentlichen geschlossenen und im Wesentlichen ringförmig um die Lage L2 umlaufenden Ring verschließt. Der Schaltungsträger L1 weist zwei Öffnungen FK ("Füllkanal") im Bereich des umlaufenden Kanals K, der durch das Einbringen der Barriere B aus dem vorherigen Luftspalt gebildet wurde, auf. Durch die Öffnungen FK ist es möglich, den Kanal K (Ringspalt) mit Isoliermaterial zu verfüllen, insbesondere mit einer elektrisch isolierenden Vergussmasse.

Die Isolationsfestigkeit der Anordnung ergibt sich dabei zum einen aus den Eigenschaften des Isoliermaterials, und zum anderen aus dem geringsten Abstand zwischen potentialbehafteten Teilen (hier also den potentialführenden Teil der Lage L2) und der Barriere B, die in diesem Fall beispielsweise Erdpotential haben kann. Wegen der besseren Isolationseigenschaften des Füllmaterials bzw. Isoliermaterials (Vergussmasse) im Vergleich zu Luft kann der Überstand, den die dritte Lage L3 über der Lage L2 aufweist, trotz des Platzbedarfs für die Barriere B insgesamt verkleinert werden.

Durch eine besondere Ausgestaltung des strukturierten Bereiches des zweiten Schaltungsträgers L3 in dem Bereich, in dem die Barriere B aufgebracht werden soll, ist es möglich, als Barriere B einen umlaufenden und mit dem anderen Schaltungsträger L1 (in der Figur nicht dargestellt) stoffschlüssig zu verbindenden und gegenüber dem (nicht dargestellten) Kühlkörper potentialfreien Ring vorzusehen. Diese dichte Barriere B bildet dabei die "Gussform" für eine Isolationsmasse, die beim Kavitätenverguss eingefüllt werden kann. Mittels eines strukturierten Grabens (siehe dazu auch die Öffnungen FK in der Figur) kann dann ein Fließkanal aufgebaut werden, der mit der Vergussmasse auch bei geringer Spaltgängigkeit sicher gefüllt werden kann. Das Füllmaterial (Isoliermasse, Vergussmasse) kann also über die Öffnungen FK in den Füllraum K ("Kavität") gelangen und füllt den Vergussraum des strukturierten Isolationsgrabens auf. Der umlaufende, stoffschlüssig angebundene Kavitätenabschluss (Barriere B) ist durch den "Graben" potentialfrei gegenüber den innenliegenden, mit potentialbehafteten Schaltungsteilen ausgeführt. Zusätzlich bildet diese Barriere also, wie bereits erläutert, einen Teil der Gussform für das Vergussmaterial und verhindert damit ein Austreten des Vergussmaterials während des Einfüllvorgangs.

Durch die geschilderte Anordnung und das geschilderte Herstellungsverfahren können etliche Vorteile erzielt werden. Ein umlaufender Isolationsüberhang wird vermieden, dadurch geringerer Platzbedarf, reduzierte Bruchempfindlichkeit beim Handling und bei der Montage. Partikeleinflüsse werden minimiert (Kapselung). Durch den Wegfall des Überhangs können luft- und kriechstreckenreduzierende Partikel außerhalb des Kavitätenabschlusses ausgeschlossen werden. Isolationsmaterial für die Reduzierung der Luft- und Kriechstrecke kann einfach über den Kavitätenverguss mit appliziert werden. Es entfällt der zusätzliche Prozessschritt zum Vergießen/Underfillen des Überhangs. Die Ecken des zweiten Schaltungsträgers L3 außerhalb des Kavitätenabschlusses können zur Anpassung des Spaltmaßes zwischen Schaltungsträger 1 und 2 genutzt werden. Dies ermöglicht z. B. einen Verzicht auf die Ausformung einer Kavität in der Leiterplatte. Da außerhalb des Kavitätenabschlusses keine Luft- und Kriechstrecken eingehalten werden müssen, kann dies z. B. durch Differenzätzen bei der Herstellung der leitfähigen Strukturierung auf der Isolationslage des zweiten Schaltungsträgers L3 erreicht werden. Die Wirksamkeit des Isolationsringes kann einfach abgeprüft werden, da zwischen der umlaufend stoffschlüssig angebundenen Barriere und der inneren potenzialbehafteten Fläche eine Prüfspannung angelegt werden kann.

## Patentansprüche

1. Isolation für eine mehrlagige elektrische Schaltung, wobei eine erste Lage (L1) der Schaltung durch einen ersten Schaltungsträger gebildet ist,
wobei auf der ersten Lage eine zweite Lage (L2) angeordnet ist, insbesondere eine Oberfläche eines auf dem ersten Schaltungsträger montierten Leistungshalbleiters oder eine andere potentialbehaftete Fläche,
wobei die erste Lage (L1) die zweite Lage (L2) allseitig überragt,
wobei eine dritte Lage (L3), insbesondere ein zweiter Schaltungsträger, auf der zweiten Lage (L2) angeordnet ist, und
wobei auch die dritte Lage (L3) die zweite Lage (L2) allseits überragt,
**dadurch gekennzeichnet,**
**dass** zwischen der ersten (L1) und der dritten Lage (L3) vollumfänglich um die zweite Lage (L2) herum und von dieser zweiten Lage (L2) jeweils beabstandet eine Barriere (B) angeordnet ist und wobei die Barriere (B) an der ersten Lage (L1) und der dritten Lage (L3) jeweils anliegt oder mit dieser jeweils stoffschlüssig verbunden ist, so dass zwischen der ersten (L1) und der dritten Lage (L3) und zwischen den Seiten der zweiten Lage (L2) und der Barriere (B) ein Füllraum (K) gebildet ist, und
**dass** der Füllraum (K) mit einem Isoliermaterial verfüllt ist.

2. Isolation nach Patentanspruch 1,
**dadurch gekennzeichnet,**
**dass** die erste Lage (L1) und die dritte Lage (L3) auf der jeweils der zweiten Lage zugewandten Seite zumindest im Bereich des Füllraums (K) elektrisch isolierend ausgebildet oder beschichtet sind.

3. Isolation nach einem der vorhergehenden Patentansprüche,
**dadurch gekennzeichnet,**
**dass** der Füllraum (K) im Wesentlichen umlaufend um die zweite Lage (L2) herum ausgebildet ist.

4. Isolation nach einem der vorhergehenden Patentansprüche,
**dadurch gekennzeichnet,**
**dass** die erste und/oder die dritte Lage (L3) im Bereich des Füllraums (K) zumindest eine Öffnung zur Befüllung des Füllraums (K) mit dem Isoliermaterial, insbesondere einem isolierenden Vergussmaterial, aufweisen.

5. Isolation nach einem der vorhergehenden Patentansprüche,
**dadurch gekennzeichnet,**
**dass** die Barriere (B) mit der ersten und/oder der dritten Lage stoffschlüssig verbunden ist.

6. Isolation nach Patentanspruch 5,
**dadurch gekennzeichnet,**
**dass** die erste und/oder die dritte Lage (L3) im Bereich ihres Anschlusses an die Barriere (B) eine Metallisierung aufweisen, insbesondere nach Art einer Leiterbahn, und dass die Barriere (B) mit der Metallisierung jeweils verlötet, verschweißt, verklebt oder versintert ist.

7. Isolation nach einem der vorhergehenden Patentansprüche,
**dadurch gekennzeichnet,**
**dass** die Barriere (B) aus Metall, insbesondere aus Lötmaterial besteht.

8. Isolation nach Patentanspruch 7,
**dadurch gekennzeichnet,**
**dass** die Barriere (B) gegenüber potentialführenden Teilen, insbesondere gegenüber der zweiten Lage, auf einem anderen elektrischen Potential ist.

9. Isolation nach einem der Patentansprüche 1 bis 5,
**dadurch gekennzeichnet,**
**dass** die Barriere (B) aus einem Isoliermaterial, insbesondere aus einem elastischen Isoliermaterial, gebildet ist.

10. Verfahren zur Herstellung einer Isolation für eine mehrlagige elektrische Schaltung,
wobei eine erste Lage (L1) der Schaltung durch einen ersten Schaltungsträger gebildet ist,
wobei auf der ersten Lage eine zweite Lage (L2) angeordnet ist, insbesondere eine Oberfläche eines auf dem ersten Schaltungsträger montierten Leistungshalbleiters oder eine andere potentialbehaftete Fläche,
wobei die erste Lage (L1) die zweite Lage (L2) allseitig überragt,
wobei eine dritte Lage (L3), insbesondere ein zweiter Schaltungsträger, auf der zweiten Lage angeordnet ist, und wobei auch die dritte Lage (L3) die zweite Lage (L2) allseits überragt,
**dadurch gekennzeichnet,**
**dass** zwischen der ersten und der dritten Lage vollumfänglich um die zweite Lage (L2) herum und von dieser beabstandet eine Barriere (B) angeordnet wird und wobei die Barriere (B) an der ersten Lage und der dritten Lage jeweils angelegt oder mit dieser jeweils stoffschlüssig verbunden wird, so dass zwischen der ersten und der dritten Lage und zwischen den Seiten der zweiten Lage und der Barriere (B) ein Füllraum (K) gebildet wird, und
**dass** der Füllraum (K) mit einem Isoliermaterial verfüllt wird.
